Europäisches Patentamt

European Patent Office

Office européen des brevets

(11) Publication number: **0 127 814**
**B1**

# EUROPEAN PATENT SPECIFICATION

(45) Date of publication of patent specification: **25.11.87**

(21) Application number: **84105543.7**

(22) Date of filing: **16.05.84**

(51) Int. Cl.⁴: **H 01 L 21/28,** H 01 L 29/08

(54) **Process for forming a narrow mesa on a substrate and process for making a self-aligned gate field effect transistor.**

| | |
|---|---|
| (30) Priority: **06.06.83 US 501463** | (73) Proprietor: **International Business Machines Corporation**<br>**Old Orchard Road**<br>**Armonk, N.Y. 10504 (US)** |
| (43) Date of publication of application:<br>· **12.12.84 Bulletin 84/50** | |
| (45) Publication of the grant of the patent:<br>**25.11.87 Bulletin 87/48** | (72) Inventor: **Fowler, Alan Bicksler**<br>**3511 Kamhi Drive**<br>**Yorktown Heights New York 10598 (US)**<br>Inventor: **Hartstein, Allan Mark**<br>**5 Deborah Lane**<br>**Chappaqua New York 10514 (US)** |
| (84) Designated Contracting States:<br>**DE FR GB** | |
| (56) References cited:<br>**EP-A-0 066 675**<br>**US-A-3 837 935**<br>**US-A-4 074 300**<br>**US-A-4 358 340**<br><br>**IBM TECHNICAL DISCLOSURE BULLETIN, vol. 13, no. 11, April 1971, New York, USA; L.M. TERMAN "MOSFET structures using selective epitaxial growth", pages 3279-3280** | (74) Representative: **Hobbs, Francis John**<br>**IBM United Kingdom Limited Intellectual Property Department Hursley Park**<br>**Winchester Hampshire SO21 2JN (GB)** |

Courier Press, Leamington Spa, England.

## Description

This invention relates to processes for making a self-aligned gate field effect transistor having a narrow gate region.

The speed or frequency response of field effect transistor type devices is limited by the transit time of the carriers (electrons or holes, depending on the substrate doping) and the capacitance of the gate. There have been efforts in the art to fabricate short channel field effect transistors in order to reduce the transit time and capacitance of the gate. However, those processes suggested in the prior art are somewhat complicated and not especially reproducible. Exemplary of certain techniques attempted or suggested for providing short channel FETs involve the relative etching rates of metals and silicon dioxide, overlapping gate structures, serial diffusions, and converging crystallographic plane preferential etching.

The invention seeks to provide simple methods for making a self-aligned gate field effect transistor.

US—A—4,358,340 discloses a process for making a self-aligned field effect transistor comprising providing a vertical step in a layer of isolation material formed on a semiconductor substrate; depositing a conductor layer over the layer of isolation material; removing the thinner portion of the conductor layer to provide a very narrow conductor mask adjacent the step in the layer of isolation material; etching away all of the layer of isolation material not covered by the very narrow conductor mask down to the substrate to produce an insulated gate; and then using the insulated gate as a mask for the implantation or diffusion of source and drain regions on opposite sides of the insulated gate.

EP—A—66675 discloses a process for making a field effect transistor having a narrow control gate located beneath an overlap gate by forming a trench having a vertical sidewall in a gate oxide region over the channel region of the device, vapour depositing metal in the trench in the gate oxide region at such an angle that a thicker metal coating is formed on the vertical sidewall than over the remainder of the trench and then etching away the deposited metal in the trench (see EP—A—66675) to leave only a metal coating on the sidewall to serve as the narrow control gate.

A process for making a self-aligned gate field effect transistor comprises, according to one aspect of the invention, providing a vertical step in a layer of isolation material formed on a semiconductor substrate; vapour depositing a layer of metal over the layer of isolation material at an angle sufficient to provide a thicker metal deposit adjacent to the step than over the horizontal surface of the isolation material; removing the thinner portion of the metal layer to provide a very narrow metal mask adjacent the step in the layer of isolation material; etching away all of the layer of isolation material not covered by the very narrow metal mask down to the substrate in order to produce a mesa of the isolation material; and depositing doped semiconductor material both on the top of the mesa and on the horizontal surfaces of the substrate on both sides of the mesa in order to simultaneously form a gate region on top of the mesa and source and drain regions on opposite sides of the mesa.

A process for making a self-aligned gate field effect transistor comprises, according to another aspect of the invention, providing a vertical step in a layer of isolation material formed on a semiconductor substrate; vapour depositing a layer of metal over the layer of isolation material at an angle sufficient to provide a thicker metal deposit adjacent to the step than over the horizontal surface of the isolation material; removing the thinner portion of the metal layer to provide a very narrow metal mask adjacent the step in the layer of isolation material; etching away all of the layer of isolation material not covered by the very narrow metal mask down to the substrate in order to produce a mesa of the isolation material; depositing doped semiconductor material both on the top of the mesa and on the horizontal surfaces of the substrate on both sides of the mesa; removing the mesa and the doped semiconductor on the top thereof; oxidizing the exposed substrate surface to provide a gate oxide; and forming a gate over the gate oxide.

How the invention can be carried out will now be described by way of example, with reference to the accompanying drawings, in which:—

Figures 1.1 to 1.7 represent various stages in the fabrication of a field effect transistor; and

Figures 2.1 to 2.8 represent various stages in the fabrication of another field effect transistor.

The following description of fabrication steps is directed to the preferred use of a p-type silicon substrate and n-type carriers (electrons) with n-type source and drain regions. Alternatively, an n-type substrate and p-type diffused or implanted dopant impurities in the source and drain regions can be employed in p-channel FET technology. When the description refers to n-type impurities, the process steps are applicable to p-type impurities and vice versa. Also, the present invention is applicable to susbtrates other than silicon. Also, as used herein, the term "metallic type interconnection lines" or "high conductivity interconnection lines" refer to metal lines, such as aluminium as well as non-metallic materials (e.g., highly doped polysilicon or intermetallic silicides) which nevertheless, can have conductivities of the magnitude generally possessed by conductive metals. Also, when reference is made to impurities of a "first type" and to impurities of a "second type", it is understood that the second type refers to opposite conductivity type to the "first type". That is, if the "first type" is p, then the "second type" is n. If the "first type" is n, then the "second type" is p.

Although the fabrication process to be described uses the preferred material, aluminium for the gate and metallic interconnections, other materials can be employed for that purpose. In particular, the gate and metallic interconnections can be formed from refractory metals in addition to aluminium or silicides thereof. A refractory metal within the context of the present description is a metal which can withstand the high temperatures experienced during the fabrication without degrading to an undesired degree. Examples of some suitable refractory metals include tungsten, tantalum, hafnium, and rhodium. Examples of some suitable silicides include tungsten silicide, tantalum silicide, hafnium silicide, and rhodium silicide.

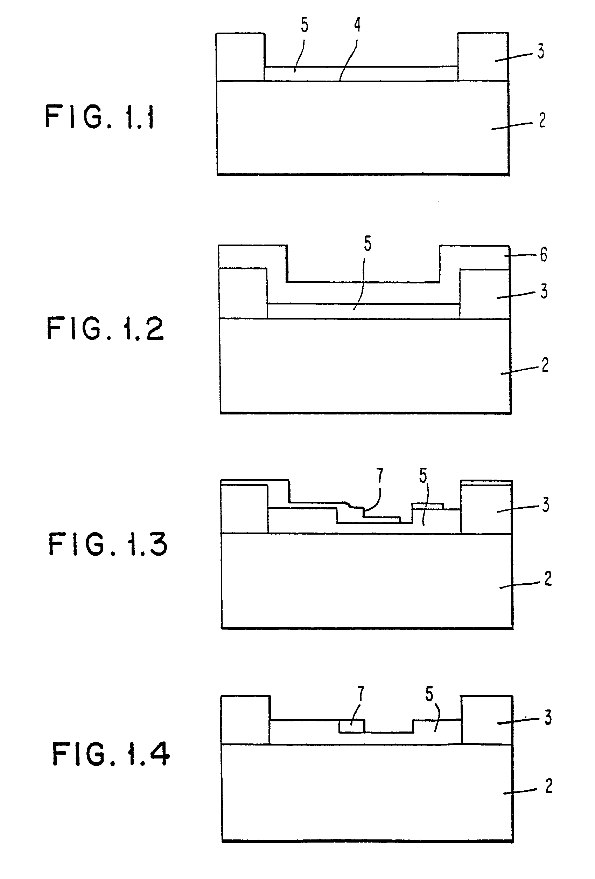

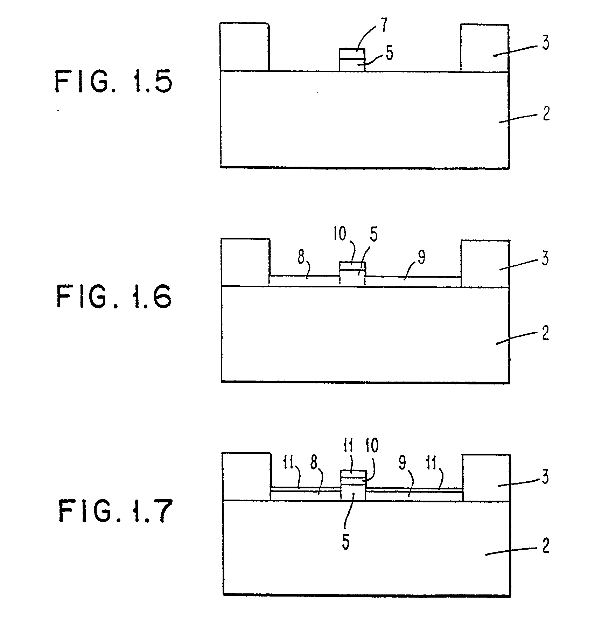

Referring to Figure 1.1, there is shown a p-type silicon substrate 2 having any desired crystal orientation (e.g., <100>). The p-type silicon substrate 2 is prepared by slicing and polishing a p-type boule grown in the presence of a p-type dopant such as boron following conventional crystal growth techniques. Other p-type dopants for silicon include aluminium, gallium, and indium.

Field oxide isolation 3 can be fabricated by any of several known procedures including thermal oxidation of the semiconductor substrate or by well-known vacuum or chemical vapour deposition techniques. Furthermore, the field oxide may be formed above the semiconductor surface or it may be partially or fully recessed into the semiconductor substrate. An example of one such procedure is the fully recessed oxide isolation technique disclosed in US—A—3,899,363.

For the purpose of illustration, a non-recessed field isolation oxide 3 will be used. The field isolation regions are generally about 400 to 1000 nm thick. The field oxide regions 3 are delineated by employing a lithographic mask. The mask is of a transparent material having opaque portions in a predetermined pattern. Using a photolithographic technique, the field oxide 3 is etched from that area 4 wherein a thin oxide layer 5 is to be subsequently provided. The layer of silicon dioxide 5 is grown on or deposited onto the silicon substrate 2 in the area 4. This silicon dioxide, which is usually about 10 to 100 nm thick, can be formed by thermal oxidation of the silicon surface at 1,000°C in the presence of dry oxygen.

Next, a masking material 6 is deposited over the structure (see Figure 1.2). A particular material employed is aluminium, which can be deposited by known vapour deposition techniques. A preselected hole is then etched into the masking layer 6 by a known masking technique, thereby forming a mask for subsequent etching of the oxide layer 5 which has been exposed by the removal of the masking material 6. For instance, the aluminium can be etched employing a known etchant such as a composition containing about 1 part by volume of nitric acid, about 4 parts by volume of water, and about 20 parts by volume of phosphoric acid, such an etch can be accomplished at room temperature with about 0.26 nm being removed per second.

Next, a depression or step is formed in the oxide layer 5, as illustrated in Figure 1.3, by etching the oxide, preferably by reactive ion etching, to remove oxide not protected by the aluminium layer. The etch employed should be a directional etching procedure to produce a well-defined step in the oxide. Preferably the amounts etched away should be on-half of the total thickness of the oxide layer. Typical conditions of reactive ion etching include using a $CF_4$ gas at about 3.3 Pascals (25 microns) of pressure at a gas flow rate of about 40 standard cubic centimetres per minute and employing about 20 watts of power which is equivalent to a power density of about 0.073 watts per $cm^2$. These particular parameters provide for an etch rate of about 16 nm per minute.

An alternative procedure is to fully etch the silicon dioxide 5 down to the underlying silicon substrate 2 and subsequently, to regrow a thin oxide layer. For instance, a 100 nm thick oxide layer might be completely etched by this procedure and a 50 nm thick oxide layer regrown. This procedure would also produce the desired oxide step.

The remaining masking layer 6 is then stripped away. For instance, in the case of aluminium, the above described etching composition can be employed.

Next, a metal 7 is deposited, preferably by vapour deposition, angularly, such that a thicker metal deposit is provided adjacent the step compared with that over the horizontal surface of the oxide. Likewise, metal 7 is deposited as illustrated in Figure 1.3 over the entire structure with thicker metal deposit adjacent the field oxide 3 than over the horizontal surfaces of the oxide. The angle of deposition should be greater than 45°, and preferably at least about 60°, from the surface normal. The larger the angle, the better the process. The angle is less than 90° and preferably, as close to 90° as possible to deposit the metal. The most preferred angle rate is about 60° to about 80°. The difference between the thickness on the surface and that adjacent to the step is a sine-cosine relationship. For instance, at a deposition angle of about 80°, the ratio of the metal adjacent to the step to that on the surface is about 5.7:1. Any metal which can be deposited directionally, such as by vapour deposition, can be employed. Preferred metals include aluminium and gold.

In a typical application, the metal is deposited to provide a thickness of about 10 to about 500 nm adjacent the step. It is preferred that the thickness of the metal adjacent the step be about equal to the height of the step. The thickness adjacent the step is at least two times and preferably at least three times that on the surface. In a particular embodiment, about 70 nm thickness of aluminium is deposited on the step at an 80° angle. In such instance, about 12 nm thickness of aluminium is deposited on the surface.

In order to provide the small dimension, the surface aluminium coverage is then etched off, leaving a residual aluminium coverage on the oxide step (see Figure 1.4). Since the aluminium is thicker adjacent the step, etching of the aluminium on the horizontal surfaces results in leaving an amount of aluminium which is sufficient to provide the small dimensions desired. In addition, the aluminium adjacent the field oxide 3 can be removed by etching, while protecting by photolithographic technique, the aluminium adjacent the step. However, if desired, the aluminium present adjacent the field oxide 3 need not be removed since it is remote from the gate region.

The etching of the aluminium at this stage can be quick dip etch which can employ the etching composition mentioned hereinabove for the initial etch requirements. It is preferable that the etching be somewhat controlled and slow so as not to remove more than necessary from the step portion of the structure. If desired, the aluminium can be etched using reactive ion etching, sputtering, or ion milling techniques.

Typically, the aluminium portion remaining will be up to a maximum of about 500 nm in length and preferably, at least about 10 nm in length. Generally, the length of the aluminium remaining is about 15 to about 300 nm and more usually, about 15 to about 50 nm. Lengths of about 10 to 15 nm are readily produced by the process.

The device, at this stage of the fabrication, is shown in Figure 1.4.

The remaining aluminium layer 7 is now employed as a mask for an etching operation in which the oxide material 5 which is not beneath and protected by aluminium portion 7 is removed. Preferably a reactive ion etching technique is used in this stage of the process. A directional etching procedure should be used wherein typical conditions include using a $CF_4$ gas at about 3.3 Pascals (25 microns) of pressure at a gas flow rate of about 40 standard cubic centimetres per minute and employing about 20 watts of power which is equivalent to a power density of about 0.073 watts per $cm^2$. These particular parameters provide for an etch rate of about 16 nm per minute.

During this reactive ion etching, it is desirable to coat the field oxide isolation regions 3 with a metal such as aluminium in order to prevent etching thereof. However, it is not necessary to provide a metal coating over the field oxide since it is significantly thicker than the oxide regions 5 in the device areas and so a substantial portion of the field oxide 3 will remain after the directional reactive ion etching is completed even if it is not protected by a metal such as aluminium. The silicon dioxide 5 is etched all the way down to the silicon substrate layer as illustrated in Figure 1.5.

The aluminium layer 7 is then removed, for example by a chemical etch, to leave a silicon dioxide mesa 5 as illustrated in Figure 1.6. The aluminium 7 can be removed by employing an etchant such as a composition containing about 1 part by volume of nitric acid, about 4 parts by volume of water, and about 20 parts by volume of phosphoric acid. Such an etch can be accomplished at room temperature with about 0.26 nm being removed per second.

A thin layer 8, 9, 10 such as at least about 15 nm and usually not in excess of about one-half the thickness of oxide 5 of heavily doped n+ silicon is deposited at the sides of the mesa silicon dioxide 5 and atop the mesa silicon dioxide 5 to provide the structure shown in Figure 1.6. The doped silicon layers 8 and 9 do not entirely coat the sidewalls of the silicon dioxide mesa and do not electrically short out the doped silicon deposit 10 on top of the oxide mesa 5.

The doped silicon layers 8, 9, and 10 can be formed by conventional vapour deposition which provides amorphous silicon or polysilicon which is then recrystallized to provide polycrystalline silicon by heating to temperatures of about 700°C. In addition, the doped silicon layers 8, 9, and 10 can be formed by a Si molecular beam epitaxy technique carried out in vacuum at temperatures about 700°C. Molecular beam epitaxy is an evaporative directional coating technique whereby single crystal silicon layers grow epitaxially only on bare silicon surfaces. On the silicon dioxide surfaces, polycrystalline silicon is formed. Such a process would result in source and drain regions 8 and 9 respectively being single crystal silicon, whereas the gate portion 10 would be polycrystalline silicon. In the alternative, the silicon regions 8 and 9 can be provided by chemical vapour deposition which would provide silicon only on the silicon surfaces provided the $SiO_2$ regions were clean.

In this technique, the gate portion 10 can be formed with the metallic-type interconnections in the following step of the process.

The above described methods for providing the source and drain regions help make it possible to obtain very short devices since conventional methods of doping (e.g.—ion implantation and thermal diffusion) result in a greater degree of diffusion of dopant beneath the gate region. Therefore, if the gate region is too short, a shorting path between source and drain could occur when using the conventional techniques.

Metallic type interconnections can then be provided to the source, drain, and gate regions by known techniques, for example vapour deposition. The metallic-type high electrical conductivity interconnections can be metal such as aluminium or preferably a metal silicide formed by sintering after deposition of the metal.

Next, a photoresist layer (not shown) is applied to the assembly. The resist material is exposed with ultra-violet radiation using a predetermined mask pattern and the exposed regions of the resist are dissolved away. Then the structure is treated to remove the portions of the conductive material not protected by the resist. The structure achieved is illustrated in Figure 1.7.

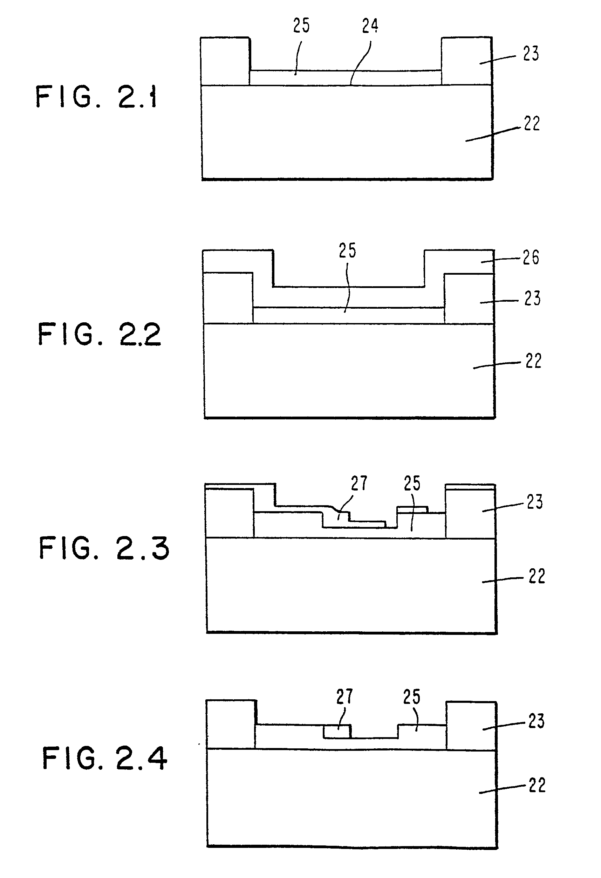

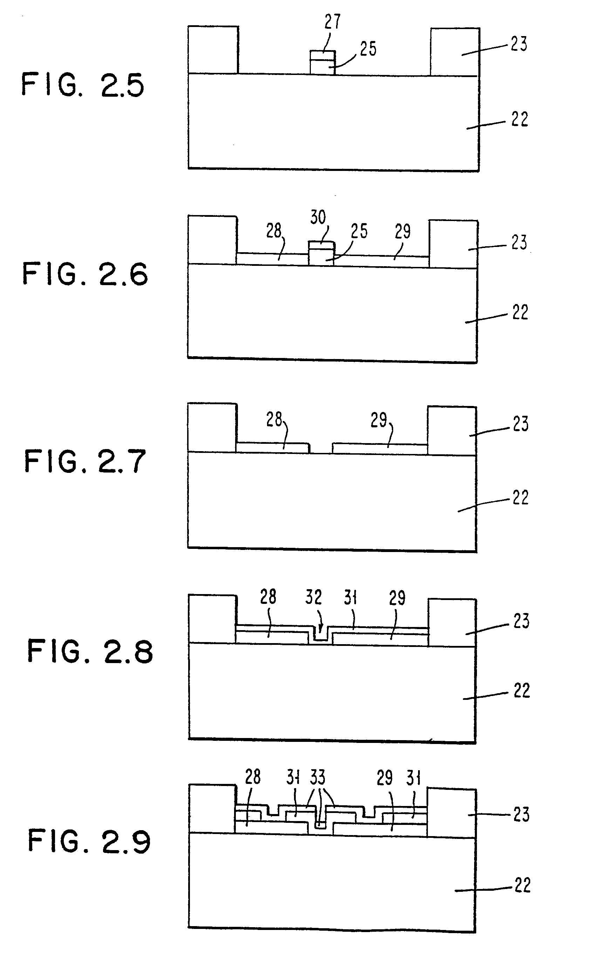

Figures 2.1 to 2.8 illustrate another fabrication sequence employing the techniques of the present invention. In Figure 2.1 there is shown a p-type silicon substrate 22 having any desired crystal orientation (e.g., <100>).

Field oxide isolation 23 can be formed by any of several known procedures including thermal oxidation of the semiconductor substrate or by well-known vacuum or chemical vapour deposition techniques. Furthermore, the field oxide may be formed above the semiconductor surface or it may be partially or fully recessed into the semiconductor substrate. For the purpose of illustration of the procedure of the present invention, a non-recessed field isolation oxide 23 will be used. The field isolation regions are generally about 400 to about 1000 nm thick. The field oxide regions 23 are delineated by employing a photolithographic mask. The mask is of a transparent material having opaque portions in a predetermined pattern. The field oxide 23, using a photolithographic technique is etched from the area 24 wherein a thin oxide layer 25 is to be subsequently provided. The layer of silicon dioxide 25 is grown on or deposited onto the silicon substrate in the area 24. This silicon dioxide, which is usually about 10 to about 100 nm thick, can be formed by theral oxidation of the silicon surface at 1000°C in the presence of dry oxygen.

Next, a metallic masking layer 26 is deposited over the structure (see Figure 2.2). A particularly suitable metal is aluminium which can be deposited by known vapour deposition techniques. A preselected hole is then etched into the masking layer 26 by a known masking technique, thereby forming a mask for subsequent etching of the oxide layer 25 which has been exposed by the removal of a portion of the masking layer 26. For instance, the aluminium masking layer can be etched employing a known etchant such as a composition of the type mentioned hereinabove.

Next, a depression or step is formed in the oxide layer 25, as illustrated in Figure 2.3, by etching the oxide, preferably by reactive ion etching, to remove oxide not protected by the aluminium masking layer. A directional etching procedure should be used to produce a well-defined step in the oxide. Preferably the amounts etched away should be one-half of the total thickness of the oxide layer. Typical conditions of reactive ion etching include using $CF_4$ gas at about 3.3 Pascals (25 microns) of pressure at a gas flow rate of about 40 standard cubic centimetres per minute and employing about 20 watts of power which is equivalent to a power density of about 0.073 watts per $cm^2$.

An alternative procedure is to fully etch the silicon dioxide 25 down to the underlying silicon substrate 22 and subsequently to regrow a thin oxide layer. For instance a 100 nm oxide layer might be completely etched by this procedure and a 50 nm oxide layer regrown. This procedure would also produce the desired oxide step.

The remaining portion of masking layer 26 is then stripped away. For instance, in the case of aluminium, the above mentioned etching composition can be employed.

Next, a metal 27 is angularly deposited, preferably by vapour deposition so that a thicker metal deposit is provided adjacent the step compared with that over the horizontal surface of the oxide. Metal 27 is deposited as illustrated in Figure 2.3 over the entire structure with thicker metal deposit adjacent the field oxide 23 than over the horizontal surfaces of the oxide.

The angle of deposition should be greater than 45° and preferably at least about 60°, from the surface normal. The larger the angle, the better the process. The angle is less than 90° and preferably, as close to 90° as possible to deposit the metal. The most preferred angle range is about 60° to about 80°. The difference between the thickness on the surface and that adjacent to the step is a sine-cosine relationship. For instance, at a deposition angle of about 80°, the ratio of the thickness of the metal adjacent to the step to that on the surface is about 5.7:1. Any metal which can be deposited directionally, such as by vapour deposition can be employed. Preferred metals include aluminium and gold.

In a typical application, the metal is deposited to provide a thickness of about 10 to about 500 nm adjacent the step. It is preferred that the thickness of the metal adjacent the step be about equal to about the height of the step. The thickness adjacent the step is generally at least two times, and preferably at least three times, that on the surface. In a particular embodiment, about 70 nm thickness of aluminium is deposited on the step at an 80° angle. In such instance, about 12 nm thickness of aluminium is deposited on the surface.

In order to provide the small dimension, the surface aluminium coverage is then etched off, leaving a residual aluminium coverage on the oxide step (see Figure 2.4). Since the aluminium is thicker adjacent the step than on the horizontal surface, etching of the aluminium on the horizontal surface results in leaving an amount of aluminium which is sufficient to provide the small dimensions desired. In addition, the aluminium adjacent the field oxide 23 can be removed by etching, while protecting by photolithographic technique, the aluminium adjacent the step. However, if desired, the aluminium present adjacent the field oxide 23 need not be removed since it is remote from the gate region.

The etching of the aluminium at this stage can be a quick dip etch which can employ the etching composition mentioned hereinabove for the initial etch requirements. It is preferably that the etching be somewhat controlled and slow so as not to remove more than necessary from the step portion of the structure.

If desired, the aluminium can be etched using a reactive ion etching, sputtering, or ion milling technique.

Typically, the aluminium portion remaining will be up to a maximum of about 500 nm in length, and preferably, at least about 10 nm in length. Generally, the length dimension of the aluminium remaining is about 15 to about 300 nm and more normally, about 15 to about 50 nm. Lengths of about 10 to 15 nm are readily produced by the process.

The device at this stage of the fabrication is shown in Figure 2.4.

The remaining portion of aluminium layer 27 is now employed as a mask for etching away the oxide material 5 which is not beneath and protected by aluminium portion 27. Preferably a reactive ion etching technique is employed in this stage of the process. A directional etching procedure should be used wherein typical conditions include using a $CF_4$ gas at about 3.3 Pascals (25 microns) of pressure at a gas flow rate of about 40 standard cubic centimetres per minute and employing about 20 watts of power which is equivalent to a power density of about 0.073 watts per $cm^2$.

During this reactive ion etching, it is desirable to coat the field oxide isolation regions 23 with a metal such as aluminium in order to prevent etching thereof. However, it is not necessary to provide a metal coating over the field oxide since it is significantly thicker than the oxide regions 25 in the device areas so that a substantial portion of the oxide 23 will remain after the directional reactive ion etching is completed even if the field oxide regions are not protected by a metal such as aluminium. The silicon dioxide is etched all the way down to the silicon substrate layer as illustrated in Figure 2.5.

The aluminium layer 27 is then removed, for example by a chemical etch to leave a silicon dioxide mesa 25 as illustrated in Figure 2.6. The aluminium can be removed by employing an etchant of the type mentioned hereinabove.

A thin layer such as at least about 15 nm thick and usually not in excess of about one-half of the thickness of dioxide 25, of heavily doped n+ silicon is deposited at the sides of the mesa silicon dioxide 25. The doped silicon layers 28 and 29 do not entirely coat the sidewalls of the silicon dioxide mesa, as shown in Figure 2.6.

The silicon layers 28, 29, and 30 can be formed by conventional vapour deposition which provides amorphous or polysilicon which is then recrystallized to provide polycrystalline silicon by heating to temperatures of about 700°C. In addition, the silicon layers 28, 29, and 30 can be formed by a Si molecular beam epitaxy technique carried out under vacuum at temperatures in excess of 700°C. Such a process would result in source and drain regions 28 and 29, respectively, being single crystal silicon, whereas the portion 30 would be polycrystalline silicon Alternatively, the silicon layers 28 and 29 can be provided by chemical vapour deposition which would provide silicon only on the silicon surfaces, provided the $SiO_2$ regions were clean.

The $SiO_2$ mesa 25 is now removed for example by chemical etching, which also results in lifting off of the layer 30 of n+ polycrystalline silicon, if present, on top of the mesa (see Figure 2.7). For instance, the $SiO_2$ mesa can be etched using a solution of buffered hydrofluoric acid.

Since the field oxide regions 23 are much thicker than $SiO_2$ region 25, etching of the regions 25 will not result in removal of any significant amount of the regions 23. Moreover, if desired, the oxide regions 23 can be protected by conventional photolithographic techniques during the etching of region 25.

The exposed silicon surfaces 22, 28, and 29 can be oxidized to provide the desired gate oxide 31 (see Figure 2.8). An advantage of the present invention is that the gate oxide layer 31 can be made relatively thin such as about 5 to about 10 nm thick and the source and drain contacts can be of relatively low resistivity. This allows the device to be switched at low enough gate voltages to function in logic circuitry.

High electrical conductivity lines are connected to the source 28, drain 29, and gate region 32.

Electrical connections are formed by applying a photoresist layer to the assembly. The resist materials are exposed with ultraviolet radiation using a lithographic masking pattern, and the exposed regions of the resist are dissolved away. Next, the structure is treated to remove the portions of the oxide not protected by the resist material. For instance, the structure is immersed in a solution of buffered hydrofluoric acid to provide contact holes or vias through the oxide insulation layer 31 to allow electrical connection to be made to the source and drain of the FET. The remaining photoresist above the etched silicon dioxide is then removed by dissolving in a suitable solvent.

Next, metallic-type high electrical conductivity interconnection line material 33, preferably a metal, is deposited and the interconnection pattern is delineated. An example of a highly conductive material commonly used for interconnection is aluminium. The high electrical conductivity material, such as aluminium, may be deposited by sputtering or preferably by vapour deposition.

Next, a photoresist layer (not shown) is applied to the assembly. The resist material is exposed with ultra-violet radiation using a predetermined mask pattern and the exposed regions of the resist are dissolved away. Then the structure is treated to remove the portions of conductive material not protected by the resist. The structure at this stage is illustrated in Figure 2.9. If some minor deposition of metal should occur on the sidewalls, making electrical contact to the gate region 32 from the source and drain regions, it can be readily removed by a quick dip etch.

The fabrication technique described hereinbefore makes it possible to provide a field effect transistor having a very narrow gate which is self-aligned with the source and drain regions and which does not overlap the source and drain.

An advantage of this fabrication technique is that the alignment of the step in the well need not be very precise. The well is relatively large and the step merely has to be located somewhere in the middle thereof so that it aligns with a gate pad.

**Claims**

1. A process for making a self-aligned field effect transistor comprising, providing a vertical step in a layer (5) of isolation material formed on a semiconductor substrate (2), vapour depositing a layer (7) of metal over the layer of isolation material at an angle sufficient to provide a thicker metal deposit adjacent to the step than over the horizontal surface of the isolation material; removing the thinner portion of the metal layer to provide a very narrow metal mask (7) adjacent the step in the layer (5) of isolation material; etching away all of the layer (5) of isolation material not covered by the very narrow metal mask down to the substrate in order to produce a mesa of the isolation material; and depositing doped semiconductor material (8, 9, 10) both on the top of the mesa and on the horizontal surfaces of the substrate on both sides of the mesa in order to simultaneously form source and drain regions on opposite sides of the mesa and a gate region on top of the mesa.

2. A process as claimed in claim 1, including providing individual high electrical conductivity connections (11) to the deposited doped semiconductor material so as to provide a source connection to the doped material on one side of the mesa, a drain connection to the doped material on the other side of the mesa and a gate connection to the doped material on top of the mesa.

3. A process for making a self-aligned field effect transistor comprising, providing a vertical step in a layer (25) of isolation material formed on a semiconductor substrate (22); vapour depositing a layer (27) of metal over the layer of isolation material at an angle sufficient to provide a thicker metal deposit adjacent to the step than over the horizontal surface of the isolation material; removing the thinner portion of the metal layer to provide a very narrow metal mask (27) adjacent the step in the layer (25) of isolation material; and etching away all of the layer (25) of isolation material not covered by the very narrow metal mask down to the substrate in order to produce a mesa of the isolation material, depositing doped semiconductor material (28, 29, 30) both on the top of the mesa and on the horizontal surfaces of the substrate on both sides of the mesa; removing the mesa and the doped semiconductor on the top thereof; oxidizing the exposed substrate surface to provide a gate oxide (31); and forming a gate (33) over the gate oxide.

4. A process as claimed in claim 3, in which the gate oxide is about 5 to about 10 nm thick.

5. A process as claimed in claim 3 or claim 4, further including providing high electrical conductivity connections (33) to the remaining regions of doped semiconductor material.

6. A process as claimed in any preceding claim, in which the deposited metal is aluminum or gold.

7. A process as claimed in any preceding claim, in which the metal is deposited at an angle of about 80°.

8. A process as claimed in any preceding claim, in which the ratio of thickness of the metal adjacent to the step to that on the horizontal surface is at least about 2:1.

9. A process as claimed in any preceding claim, wherein the thickness of the deposited metal adjacent the step is about equal to the height of the step.

10. A process as claimed in any preceding claim, in which the maximum width of the mesa is about 500 nm.

11. A process as claimed in claim 10, in which the width of the mesa is at least about 10 nm.

12. A process as claimed in claim 10, in which the width of the mesa is at least about 15 to about 100 nm.

13. A process as claimed in any preceding claim, in which the isolation material is silicon dioxide.

**Patentansprüche**

1. Verfahren zum Herstellen eines selbstjustierten Feldeffekttransistors mit den Schritten: Erstellen einer vertikalen Stufe in einer auf einem Halbleitersubstrat (2) ausgebildeten Isolationsschicht (5), Dampfabscheiden einer Metallschicht (7) auf der Isolationsschicht unter einem Winkel, der ausreicht, um einen dickeren Metallniederschlag neben der Stufe als auf der horizontalen Oberfläche des Isolationsschichtmaterials zu liefern, Entfernen des dünneren Teils der Metallschicht, um neben der Stufe in dem Material der Isolationsschicht (5) eine sehr enge Metallmaske (7) zu bilden, Wegätzen des gesamten Materials des Isolationsschicht (5), das nicht durch die sehr schmale Metallschicht bedeckt ist, bis hinunter zum Substrat, um eine Mesastruktur des Isolationsmaterials zu erzeugen und Abscheiden von dotiertem Halbleitermaterial (8, 9, 10) sowohl auf der Oberseite der Mesa als auch auf den horizontalen Oberflächen des Substrates auf beiden Seiten der Mesa, um gleichzeitig Source- und Drainbereiche auf gegenüberliegenden Seiten der Mesa und einen Gatebereich zu bilden.

2. Verfahren nach Anspruch 1, bei dem individuelle, elektrisch gut leitende Verbindungen (11) zu dem dotierten Halbleitermaterial geschaffen werden, um dadurch eine Sourceverbindung zu dem dotierten Material auf der einen Seite der Mesa, eine Drainverbindung zu dem dotierten Material auf der anderen Seite der Mesa und eine Gateverbindung zu dem dotierten Material auf der Oberseite der Mesa zu schaffen.

3. Verfahren zum Herstellen eines selbstjustierten Feldeffekttransistors mit den Schritten: Erstellen einer vertikalen Stufe in einer auf einem Halbleitersubstrat (22) ausgebildeten Isolationsschicht (25), Dampfabscheiden einer Metallschicht (27) auf der Isolationsschicht unter einem Winkel, der ausreicht, um einen dickeren Metallniederschlag neben der Stufe als auf der horizontalen Oberfläche des Isolationsschichtmaterials zu liefern, Entfernen des dünneren Teils der Metallschicht, um neben der Stufe in dem Material der Isolierschicht (25) eine sehr enge Metallmaske (27) zu bilden, Wegätzen des gesamten Materials der Isolationsschicht (25), das nicht durch die sehr schmale Metallmaske bedeckt ist, bis hinunter zum Substrat, um eine Mesastruktur des Isoliermaterials zu erzeugen, Abscheiden von dotiertem Halbleitermaterial (28, 29, 30) sowohl auf der Oberseite der Mesa als auch auf den horizontalen Oberflächen des Substrates auf beiden Seiten der Mesa, Wegnahme des Mesa und des dotierten Halbleiters auf deren Oberseite, Oxidieren der ausgesetzten Substratoberfläche, um ein Gateoxid (31) zu bilden und Herstellen eines Gate (33) auf dem Gateoxid.

4. Verfahren nach Anspruch 3, bei dem das Gateoxid etwa 5 bis 10 nm dick ist.

5. Verfahren nach Anspruch 3 oder 4, bei dem weiterhin elektrisch gut leitende Verbindungen (33) zu den übrigen Bereichen des dotierten Halbleitermaterials erstellt werden.

6. Verfahren nach einem der vorstehenden Ansprüche, bei dem das abgeschiedene Metall Aluminium oder Gold ist.

7. Verfahren nach einem der vorstehenden Ansprüche, bei dem das Metall unter einem Winkel von etwa 80° niedergeschlagen wird.

8. Verfahren nach einem der vorstehenden Ansprüche, bei dem das Verhältnis der Dicke des Metalls neben der Stufe zu dem auf der horizontalen Fläche wenigstens 2:1 ist.

9. Verfahren nach einem der vorstehenden Ansprüche, bei dem die Dicke des neben der Stufe niedergeschlagenen Metalls etwa gleich der Höhe der Stufe ist.

10. Verfahren nach einem der vorstehenden Ansprüche, bei dem die maximale Breite der Mesa etwa 500 nm beträgt.

11. Verfahren nach Anspruch 10, bei dem die Breite der Mesa wenigstens 10 nm beträgt.

12. Verfahren nach Anspruch 10, bei dem die Breite der Mesa wenigstens etwa 15 bis etwa 100 nm beträgt.

13. Verfahren nach einem der vorstehenden Ansprüche, bei dem das Isolationsmaterial Siliziumdioxid ist.

**Revendications**

1. Procédé de fabrication d'un transistor à effet de champ auto-aligné, qui comprend la création d'un gradin vertical dans une couche (5) de matière isolante formée sur un substrat semi-conducteur (2); le dépôt par vapeur d'une couche (7) de métal sur la couche de matière isolante, suivant un angle suffisant pour engendrer un dépôt de métal plus épais à l'endroit du gradin que sur la surface horizontale de la matière isolante; l'enlèvement de la partie plus mince de la couche de métal, pour constituer un masque de métal (7) très étroit à l'endroit du gradin de la couche (5) de matière isolante; l'élimination par attaque de toute la couche (5) de matière isolante non couverte par le masque de métal très étroit, jusqu'au substrat, afin de produire une mésa ou table de matière isolante; et le dépôt d'une matière semi-conductrice dopée (8, 9, 10) à la fois sur le dessus de la table et sur les surfaces horizontales du substrat de part et d'autre de la table, afin de former simultanément des régions de source et de drain de part et d'autre de la table et une région de porte sur le dessus de la table.

2. Procédé suivant la revendication 1, comprenant la création de connexions individuelles (11), de conductivité électrique élevée, avec la matière semi-conductrice dopée déposée, de manière à réaliser une connexion de source à la matière dopée d'un côté de la table, une connexion de drain à la matière dopée de l'autre côté de la table, et une connexion de porte à la matière dopée sur le dessus de la table.

3. Procédé de fabrication d'un transistor à effet de champ auto-aligné, qui comprend la création d'un gradin vertical dans une couche (25) de matière isolante formée sur un substrat semi-conducteur (22); le dépôt par vapeur d'une couche (27) de métal sur la couche de matière isolante, suivant un angle suffisant pour obtenir un dépôt de métal plus épais à l'endroit du gradin que sur la surface horizontale de la matière isolante; l'enlèvement de la partie plus mince de la couche de métal, pour obtenir un masque de métal très étroit (27) à l'endroit du gradin de la couche (25) de matière isolante; et l'élimination par attaque de la totalité de la couche (25) de matière isolante non couverte par le masque de métal très étroit, jusqu'au substrat, afin d'engendrer une mésa ou table de la matière isolante; le dépôt d'une matière semi-conductrice dopée (28, 29, 30) à la fois sur le dessus de la table et sur les surfaces horizontales du substrat de part et d'autre de la table; l'enlèvement de la table et du semi-conducteur dopé sur le dessus de celle-ci; l'oxydation de la surface exposée du substrat, pour engendrer un oxyde de porte (31); et la formation d'une porte (33) sur l'oxyde de porte.

4. Procédé suivant la revendication 3, dans lequel l'oxyde de porte a une épaisseur de 5 nm environ à 10 nm environ.

5. Procédé suivant la revendication 3 ou la revendication 4, comprenant en outre la création de connexions (33), de conductivité électrique élevée, aux régions restantes de matière semi-conductrice dopée.

6. Procédé suivant l'une quelconque des revendications précédentes, dans lequel le métal déposé est l'aluminium ou l'or.

7. Procédé suivant l'une quelconque des revendications précédentes, dans lequel le métal est déposé suivant un angle de 80° environ.

8. Procédé suivant l'une quelconque des revendications précédentes, dans lequel le rapport de l'épaisseur du métal à l'endroit du gradin à l'épaisseur sur la surface horizontale est au moins de 2:1 environ.

9. Procédé suivant l'une quelconque des revendications précédentes, dans lequel l'épaisseur du métal déposé près du gradin est sensiblement égale à la hauteur du gradin.

10. Procédé suivant l'une quelconque des revendications précédentes, dans lequel la largeur maximale de la mésa ou table est de 500 nm environ.

11. Procédé suivant la revendication 10, dans lequel la largeur de la table est au moins de 10 nm environ.

12. Procédé suivant la revendication 10, dans lequel la largeur de la table est au moins de 15 nm environ à 100 nm environ.

13. Procédé suivant l'une quelconque des revendications précédentes, dans lequel la matière isolante est le dioxyde de silicium.

FIG. 1.1

FIG. 1.2

FIG. 1.3

FIG. 1.4

FIG. 1.5

FIG. 1.6

FIG. 1.7

FIG. 2.1

FIG. 2.2

FIG. 2.3

FIG. 2.4

FIG. 2.5

FIG. 2.6

FIG. 2.7

FIG. 2.8

FIG. 2.9